# EUROPEAN PATENT APPLICATION

(11) **EP 4 404 696 A1**
(43) Date of publication of application: **24.07.2024**
(21) Application number: 23382048.9
(22) Date of filing: 20.01.2023
(51) Int. Cl.: H05K 1/11, H05K 3/28, H05K 3/00, H05K 3/46

(54) **PRINTED CIRCUIT**

(71) Applicant: CS Centro Stirling, S.Coop., 20550 Aretxabaleta (ES)
(72) Inventor: CORDON LARRAÑAGA, Marta, 20600 EIBAR (ES); ZABALA GONZÁLEZ, Silvia, ARBEIZA 31241 (ES); IZURA GONZÁLEZ, Joaquín, 31180 ZIZUR MAYOR (ES); ESKUBI UGARTE, Mauricio, 20550 Aretxabaleta (ES)
(74) Representative: Igartua, Ismael

(57) **Abstract**

Printed circuit (1) comprising a base substrate (4) and a functional layer comprising a plurality of conductive tracks (5). The functional layer is arranged on the base substrate (4). The base substrate (4) and the functional layer comprise a main area (2) and a connection area (3) which are separated by an imaginary dividing line (6), with the connection area (3) being a prolongation of the main area (2), said connection area (3) being configured to cooperate with an electrical connector. The printed circuit (1) also comprises a protective layer (7) which covers the functional layer in the main area (2), such that said protective layer (7) does not cover the tracks (5) of the functional layer in the imaginary dividing line (6).

## Description

### TECHNICAL FIELD

The present invention relates to printed circuits, and more specifically to printed circuits comprising an encapsulating protective layer and a connection area, configured to cooperate with an electrical connector, without the protective layer.

### PRIOR ART

Printed circuits are used in most electronic components and elements. There is a great variety of printed circuits, most of them differing by their manufacturing method. On one hand, there are conventional printed circuit boards, commonly referred to as PCBs, which are characterized by the lamination of conductive tracks or paths, usually made of copper, on a rigid non-conductive base or board, usually made of a resin. Electronic components are arranged on the rigid base and electronically connected through the tracks.

However, printed circuit manufacturing is changing as a result of technological advancement, giving rise to another type of printed circuits such as flexible printed circuits, for example. These technologies are based on "printed electronics" in which tracks are printed or screen printed on a substrate, usually made of plastic, which can be flexible and may or may not be subjected to thermoforming in order to give the substrate the desired final shape. In English, other two technologies, i.e., "Printed Electronics" and "In-Mold Electronics", are distinguished when referring to printed electronics. In the "printed electronics" technology, the functional layer comprising the conductive tracks are printed or screen printed on the substrate, and in the "In-Mold Electronics" technology, the functional layer is further protected by overmolding an encapsulating material.

In this sense, JP2003124583 A describes a flexible circuit comprising a base substrate and a functional layer comprising a plurality of conductive tracks, the functional layer being arranged on the base substrate. The base substrate and the functional layer comprise a main area and a connection area which are separated by an imaginary dividing line, with the connection area being a prolongation of the main area configured to cooperate with an electrical connector, and the printed circuit also comprising a protective layer which covers the functional layer in the main area.

### DISCLOSURE OF THE INVENTION

The object of the invention is to provide a printed circuit, as defined in the claims.

The printed circuit of the invention comprises a base substrate and a functional layer comprising a plurality of conductive tracks. The functional layer is arranged on the base substrate. The base substrate and the functional layer comprise a main area and a connection area which are separated by an imaginary dividing line, with the connection area being a prolongation of the main area, said connection area being configured to cooperate with an electrical connector. The printed circuit also comprises a protective layer which covers the functional layer in the main area, such that said protective layer does not cover the tracks of the functional layer in the imaginary dividing line.

The plurality of tracks of the functional layer of the connection area is not covered by the protective layer, such that the tracks of the connection area are exposed. In the printed circuit of the invention, since the protective layer does not cover the tracks in the imaginary dividing line, if the connection area is bent towards the protective layer, for example, during the handling of the printed circuit for the final assembly thereof or for connecting the connection area to the connector, friction of the tracks against the edge of the protective layer is prevented, preventing track deterioration.

These and other advantages and features of the invention will become apparent in view of figures and detailed description of the invention.

### DESCRIPTION OF THE DRAWINGS

Figure 1 shows a perspective view of an embodiment of the printed circuit according to the invention in which a portion of the main area is shown.
Figure 2 shows a sectioned view of the printed circuit of Figure 1 according to section line II-II.

### DETAILED DISCLOSURE OF THE INVENTION

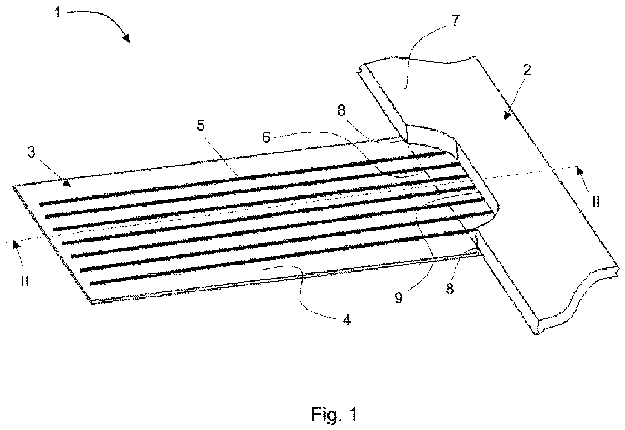

Figure 1 shows an embodiment of the printed circuit 1 according to the invention, the printed circuit 1 comprising a base substrate 4 and a functional layer comprising a plurality of conductive tracks 5. The functional layer is arranged on the base substrate 4. The base substrate 4 and the functional layer comprise a main area 2 and a connection area 3 which are separated by an imaginary dividing line 6, with the connection area 3 being a prolongation of the main area 2, said connection area 3 being configured to cooperate with an electrical connector, not shown in the drawings. The printed circuit 1 also comprises a protective layer 7 which covers the functional layer in the main area 2, such that said protective layer 7 does not cover the tracks 5 of the functional layer in the imaginary dividing line 6.

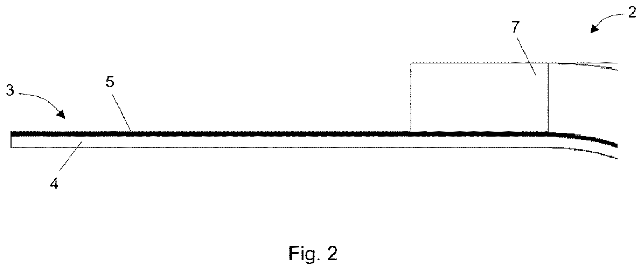

The plurality of tracks 5 of the functional layer of the connection area 3 is not covered by the protective layer 7, as can be seen in Figure 2, such that the tracks 5 of the connection area 3 are exposed. Furthermore, since the protective layer 7 does not cover the tracks 5 in the imaginary dividing line 6, if the connection area 3 is bent, for example during the handling of the printed circuit 1 for the final assembly thereof, for the packaging thereof, or for connecting the connection area 3 to the connector, on one hand, friction of the tracks 5 against the edge of the protective layer 7 is prevented when the connection area 3 is bent towards the protective layer 7, and on the other hand the tracks 5 are prevented from peeling off when the connection area 3 is bent in the opposite direction, preventing the deterioration of the tracks 5, as will be described in detail below.

The protective layer 7 covers the functional layer in the entire main area 2 except in the segment of the imaginary dividing line 6 which is traversed by the tracks 5 and in an area 10 close to said segment, as shown in Figure 1. Moreover, the protective layer 7 also covers the base substrate 4 in the entire main area 2 and at the ends 8 of the imaginary dividing line 6, but not in the area 10 close to the segment of the imaginary dividing line 6 which is traversed by the tracks 5, nor in the segment of the imaginary dividing line covering the tracks 5 intercalated with the base substrate 4.

The edge of the protective layer 7 comprises a segment 9 parallel to the imaginary dividing line 6 facing the segment of the imaginary dividing line 6 traversed by the tracks 5, said segment 9 being joined to the rest of the edge of the protective layer 7 by means of curved segments, generating a type of empty space in the protective layer 7 close to the imaginary dividing line 6.

In that sense, the edge of the protective layer 7 covering the ends 8 of the imaginary dividing line 6 becomes an imaginary pivoting axis about which the connection area 3 can pivot or bend with respect to the main area 2 or vice versa.

In the preferred embodiment of the invention, the printed circuit 1 is manufactured with the technology referred to as plastronics, commonly known as In-Mold Electronics (IME). The IME technology consists of printing or screen printing on a substrate (foil), preferably flexible, using special inks both the esthetic part of the product and the electronics or functional part. After the modeling of the 3D final product shape, preferably with the thermoforming technology, the product is encapsulated by over-injecting a plastic which protects and covers both the substrate and the functional layer.

In the preferred embodiment of the invention, the part modeled during thermoforming so that it adopts the three-dimensional final product shape is the main area 2. Although the base substrate 4 is flexible at the start of the process, the base substrate 4 of the main area 2 can become rigid after the thermoforming process, but the base substrate 4 of the connection area 3 remains flexible, such that there is a risk of the connection area 3 bending towards the protective layer 7 and/or in the opposite direction when handling the connection area 3, for example during the final assembly of the printed circuit 1, during the packaging of the printed circuit 1, or during the connection of the connection area 3 to the connector. The inflection area where the connection area 3 is bent is the imaginary dividing line 6 since the edge of the protective layer 7 covering the ends 8 of the imaginary dividing line 6 becomes the imaginary pivoting axis, where the connection area 3 can bend with respect to the main area 2. In the preferred embodiment of the invention, the connection area 3 is flat, i.e., without reliefs, but optionally the connection area 3 may comprise at least one segment with a three-dimensional configuration, for example, a corrugated configuration, but such that said connection area 3 remains flexible, where it can be bent, as described in detail above.

If the protective layer 7 were to cover the tracks 5 in the imaginary dividing line 6, upon bending the connection area 3 towards the protective layer 7, the tracks 5 would rub against the edge of the protective layer 7 and deteriorate, and upon bending the connection area in the opposite direction, the tracks 5 would peel off and also deteriorate. However, since the protective layer 7 does not cover the tracks 5 in the imaginary dividing line 6, rubbing and peeling off of the exposed tracks 5 are prevented if the protective layer 7 is bent. In other words, the edge of the protective layer 7 comprises a profile which, in the segment of the imaginary dividing line 6 which is traversed by the tracks 5, is arranged away from the imaginary dividing line 6 and therefore, if the connection area 3 is bent towards the protective layer 7, the tracks 5 do not contact the edge of the protective layer 7 and therefore do not rub against the protective layer 7, and if the connection area 3 is bent in the opposite direction, the tracks 5 do not come off (peel off) the base substrate 4, preventing the deterioration of the track 5 and therefore reducing the risk of generating defective products.

The functional layer of the printed circuit 1 of the invention may also comprise electronic components such as, for example, a capacitor, a sensor, a resistor, or even a light source, preferably a base with light emitting diodes or LEDs, and even an element acting as a light diffuser.

In the preferred embodiment of the invention, the protective layer 7 is overmolded on the base substrate 4 and the functional layer of the main area 2, encapsulating the functional layer, even if it comprises electronic components. The protective layer 7 therefore protects the functional layer of the printed circuit 1.

In the preferred embodiment of the invention, the protective layer 7 is made of plastic, preferably formed by a polymer material such as, for example, polycarbonate, being preferably transparent, and more preferably a good visible light transmitter. Optionally, the material of the protective layer 7 may comprise additives, formulations, or surface treatments (such as paint, for example), which help to improve its light diffusion properties, for example, may also be applied as well. After the overmolding process applied by injection, for example, the protective layer 7 solidifies, and therefore becomes rigid, creating an edge in the contour of the protective layer 7, i.e., creating the outer contour of the protective layer 7. The tracks 5 of the functional layer, which are preferably made of silver, may flake off if they rub against the edge of the protective layer 7, or peel off if the connection area 3 is bent away from the protective layer 7, hence the object of the invention is to arrange the edge of the protective layer 7 away from the imaginary dividing line 6, but such that the imaginary pivoting axis of the connection area 3 coincides with the imaginary dividing line 6.

After the solidification and/or curing of the protective layer 7, this layer can be rigid or flexible, depending on the material used.

As discussed, the main area 2 is more rigid than the connection area 3, not only due to the thermoforming process of the base substrate 4, but also to the protective layer 7. After the thermoforming process, the base substrate 4 of the main area 2 does not have to become rigid, but upon encapsulating same with the protective layer 7, the main area 2 usually ends up becoming rigid with the desired final shape.

In the preferred embodiment of the invention, the tracks 5 of the functional layer are printed on the base substrate 4. Different printing techniques such as, for example, screen printing, flexography, ink injection, rotogravure printing, or offset printing can be used.

In the preferred embodiment of the invention, the base substrate 4 is made of plastic, preferably polycarbonate, although other plastics are not ruled out. Optionally, the base substrate 4 may also be, for example, a fabric. The material of the base substrate 4 may optionally comprise additives or can be formulated such that they improve its properties, for example, scratch resistance or the ultraviolet (UV) ray protection.

In a variant not shown in the drawings, the printed circuit of the invention may also comprise a non-functional layer, for example, a decorative layer, arranged on the base substrate 4 in the main area 2 and also encapsulated by the protective layer 7, and/or in the connection area 3 (not encapsulated by the protective layer 7). In this case, the functional layer can be arranged on the non-functional layer. The functional layer differs from the non-functional layer in that the functional layer contributes to the correct electrical operation of the printed circuit 1, i.e., the functional layer comprises the elements required for the printed circuit 1 to work.

The base substrate 4 of the preferred embodiment is transparent, such that a non-functional layer has been applied on the base substrate 4 to change the appearance of the base substrate 4 before applying the functional layer. In that sense, in the preferred embodiment of the invention, the base substrate 4 acquires a black color as a result of the non-functional layer which, in this case, is a decorative layer, although the decorative layer may have any other color or texture.

The free end of the connection area 3 is configured to be connected to a terminal, not shown in the figures, which may be connected to the electrical connector, not shown in the figures, to allow the electrical connection of the printed circuit 1 to a control unit, not shown in the drawings, said control unit comprising a power supply or electrical outlet, said control unit being configured to manage the printed circuit 1 of the invention.

## Claims

1. Printed circuit comprising a base substrate (4) and a functional layer comprising a plurality of conductive tracks (5), the functional layer being arranged on the base substrate (4), the base substrate (4) and the functional layer comprising a main area (2) and a connection area (3) which are separated by an imaginary dividing line (6), with the connection area (3) being a prolongation of the main area (2) configured to cooperate with an electrical connector, and the printed circuit (1) also comprising a protective layer (7) which covers the functional layer in the main area (2), **characterized in that** the protective layer (7) does not cover the tracks (5) of the functional layer in the imaginary dividing line (6).

2. Printed circuit according to claim 1, wherein the protective layer (7) covers the functional layer in the entire main area (2) except in the segment of the imaginary dividing line (6) which is traversed by the tracks (5) and in an area close to said segment.

3. Printed circuit according to claim 2, wherein the protective layer (7) covers the ends (8) of the imaginary dividing line (6).

4. Printed circuit according to claim 3, wherein the edge of the protective layer (7) comprises a segment (9) parallel to the imaginary dividing line (6) facing the segment of the imaginary dividing line (6) traversed by the tracks (5).

5. Printed circuit according to claim 4, wherein the segment (9) parallel to the imaginary dividing line (6) of the edge of the protective layer (7) is joined to the rest of the edge of the protective layer (7) by means of curved segments.

6. Printed circuit according to any of the preceding claims, wherein the protective layer (7) encapsulates the functional layer of the main area (2).

7. Printed circuit according to the preceding claim, wherein the protective layer (7) is overmolded on the base substrate (4) and the functional layer of the main area (2).

8. Printed circuit according to any of the preceding claims, wherein the connection area (3) is flexible, where the connection area (3) can pivot or bend with respect to the imaginary dividing line (6).

9. Printed circuit according to any of the preceding claims, wherein the functional layer also comprises electronic components such as, for example, a light source, preferably in the form of LED, a capacitor, a resistor, or a sensor.

10. Printed circuit according to any of the preceding claims, wherein the base substrate (4) is made of plastic, preferably polycarbonate.

11. Printed circuit according to claim 10, wherein the main area (2) of the base substrate (4) and of the functional layer adopts the desired three-dimensional final shape after a thermoforming process.

12. Printed circuit according to any of the preceding claims, wherein the protective layer (7) is made of plastic, preferably polycarbonate, said protective layer (7) preferably being transparent.

13. Printed circuit according to any of the preceding claims, wherein the tracks (5) of the functional layer are printed on the base substrate (4), preferably by screen printing, flexography, ink injection, rotogravure printing, or offset printing.

14. Printed circuit according to any of the preceding claims, wherein the tracks (5) are made of silver.

15. Printed circuit according to any of the preceding claims, wherein the printed circuit (1) is manufactured with the technology referred to as plastronics, commonly known as In-Mold Electronics.
